Europäisches Patentamt

European Patent Office

Office européen des brevets

(11) Numéro de publication: **0 385 843**
**A1**

## (12) DEMANDE DE BREVET EUROPEEN

(21) Numéro de dépôt: 90400528.7

(22) Date de dépôt: 26.02.90

(51) Int. Cl.⁵: **H01L 31/02, H01L 31/0224, B23K 1/08**

(30) Priorité: **02.03.89 FR 8902707**

(43) Date de publication de la demande:
**05.09.90 Bulletin 90/36**

(84) Etats contractants désignés:
**AT BE CH DE DK ES FR GB GR IT LI LU NL SE**

(71) Demandeur: **SOLEMS S.A. Société dite:**
**3, rue Léon Blum Z.I. Les Glaises**
**F-91120 Palaiseau(FR)**

(72) Inventeur: **Billette de Villemeur, Philippe**
**6, rue de la Cossonnerie**
**F-75001 Paris(FR)**
Inventeur: **Pellerin, Jean-François**
**93, rue d'Aguesseau**
**F-92100 Boulogne(FR)**

(74) Mandataire: **Pinguet, André**
**Cabinet de Propriété Industrielle CAPRI 28**
**bis, avenue Mozart**
**F-75016 Paris(FR)**

(54) Procédé de réalisation de contacts pour des électrodes en couche mince sur du verre.

(57) Procédé de réalisation d'une borne de contact pour électrode en couche mince sur du verre comprenant, sur une plaque de verre d'une épaisseur de un à quelques mm, une électrode métallique, la face libre extérieure de l'électrode étant recouverte partiellement d'une protection isolante empêchant l'accrochage, dans lequel procédé, une électrode est laissée dégagée sur une surface de contact d'une largeur d'un à deux millimètres, caractérisé en ce que de l'étain est déposé par un bain d'étain, par le procédé dit à la vague sur ladite surface de contact, l'élément étant présenté à la vague de préférence à la température ambiante, et la durée de contact de ladite surface avec la vague étant comprise entre une demi seconde et deux secondes et la vitesse de défilement est comprise entre 1,5 et 5 mètres par minute.

Fig. 2

EP 0 385 843 A1

**Procédé de réalisation de contacts pour des électrodes en couche mince sur du verre.**

La présente invention concerne les contacts des électrodes en couche mince sur du verre et s'applique notamment aux photopiles au silicium. Dans cet exemple d'application, une telle photopile est constituée par une couche active de silicium amorphe entre deux électrodes, dont l'une est transparente, par exemple en oxyde d'étain Sn 02, pour laisser passer la lumière jusqu'au silicium. Les 3 couches, dont l'épaisseur totale est de l'ordre du micron, sont disposées sur un support formé par une plaque de verre, d'une épaisseur comprise généralement entre un demi et quelques millimètres et le plus usuellement, de l'ordre de 1 mm, l'électrode transparente étant placée contre le verre. L'autre électrode, est garnie d'une couche de protection, qui peut être déposée par sérigraphie.

La récupération du courant pose un problème. L'intensité doit être collectée sur une électrode qui présente une forme très particulière : une grande surface, et une faible épaisseur. On a donc été conduit à conformer les cellules élémentaires en forme de bandes allongées, à bord rectilignes et parallèles, et à former une borne longiforme sur un des bords. Il n'est en effet pas possible de placer un contact directement sur l'électrode, la couche conductrice est tellement mince qu'il est difficile de concevoir l'existence d'une surface réelle en contact provenant d'une déformation plastique de cette couche, quelle que soit la pression exercée par l'élément de contact du connecteur. Jusqu'à présent, on a utilisé divers procédés pour réaliser les bornes : par exemple, emploi de colle conductrice, disposée sur le bord de l'électrode, pour former une surépaisseur, ou pour rapporter un ruban de cuivre ; on utilise aussi un ruban d'aluminium, soudé à l'ultrason à l'électrode, éventuellement avec apport d'indium. On peut aussi souder un ruban de cuivre étamé. Les dépôts électrolytiques sont possibles, mais très coûteux.

La présente invention a pour objet un procédé de réalisation d'une borne de contact pour élément de ce genre, en particulier pour électrode en couche mince sur du verre comprenant, sur une plaque de verre d'une épaisseur de 1 à quelques mm, une électrode métallique, caractérisé en ce que un matériau d'étamage approprié est déposé par contact avec ladite surface en l'état fondu et la durée de contact de ladite surface avec la phase fondue est inférieure à deux secondes. Avantageusement, une électrode est étamée sur une surface de contact d'une largeur appropriée et un alliage d'étain est déposé par un bain d'étain, par le procédé dit à la vague sur ladite surface de contact, l'élément étant présenté à la vague de préférence à la température ambiante et la vitesse de défilement étant comprise entre 1,5 et 5 mètres par minute.

Dans l'opération classique de dépôt d'étain à la vague, le support (circuit imprimé par exemple) est préchauffé, et le passage est assez lent: de l'ordre de 0,50 mètre par minute. L'application de cette technique aux photopiles s'est montrée être un échec.

La partie conductrice de la photopile a une épaisseur très faible, de l'ordre du demi micron, et n'a donc pas d'inertie thermique. C'est la présence du verre (il n'est pas préchauffé) qui modifie les conditions. On a constaté que pour les vitesses habituelles de défilement sur la vague (inférieures à 2 mètres par minute) et pour des plaques de verre assez larges de 300 mm par exemple, on ne dépose pas d'étain, et on casse le verre. En principe, le verre ne supporte pas de gradients de température supérieurs à 50°C entre faces pour les faibles épaisseurs considérées. Cependant, dans le cadre de la présente invention, on a trouvé qu'il a la particularité de supporter un gradient de température pouvant aller jusqu'à 250°C entre face avant et face arrière, dans la mesure où ce gradient est momentané, mobile, et régulièrement réparti dans un sens normal à ce déplacement et ou le verre est guidé librement, sans contrainte ou sous de très faibles contraintes. Selon l'invention, on adoptera une vitesse de défilement comprise entre 1,5 et 5 mètres par minute. L'extrême faiblesse de l'inertie thermique des couches minces favorise la soudabilité. Aux faibles vitesses le flux d'étamage est dissout dans l'étain, il n'y a pas d'accrochage. Par contre, si on passe trop vite, la réaction permettant l'accrochage de l'étain n'a pas lieu.

Le procédé selon l'invention permet d'obtenir sur le bord d'une photopile en forme de bande une borne formée par une couche d'étain ayant une épaisseur de l'ordre de 10 à 50 microns. Une telle borne est connectable aisément par serrage mécanique, et l'on peut aussi bien y souder un conducteur sans apport de soudure. Dans les deux cas on a une liaison électrique de très bonne qualité. Le procédé de réalisation de la borne est simple, conduisant à de bons résultats avec peu de déchets, et d'un prix de revient économique.

D'autres caractéristiques et avantages de l'invention apparaîtront au cours de la description qui va suivre, donnée à titre d'exemple non limitatif, en regard des dessins ci-joints, et qui fera bien comprendre comment l'invention peut être réalisée.

Sur les dessins,

la figure 1 est une vue en coupe du bord d'une plaque de photopile, les proportions entre les épaisseurs des différentes couches n'étant pas respectées, pour simplifier le dessin et favoriser la compréhension, la plaque étant préparée pour recevoir une borne, avant la mise en place de celle-ci;

la figure 2 est une vue correspondante à la figure 1, après mise en place d'une borne et

la figure 3 est une représentation schématique d'une présentation d'une électrode sur une vague d'étain pour y faire adhérer une masse d'étain formant une borne.

L'invention va maintenant être décrite en référence à une pile photovoltaïque.

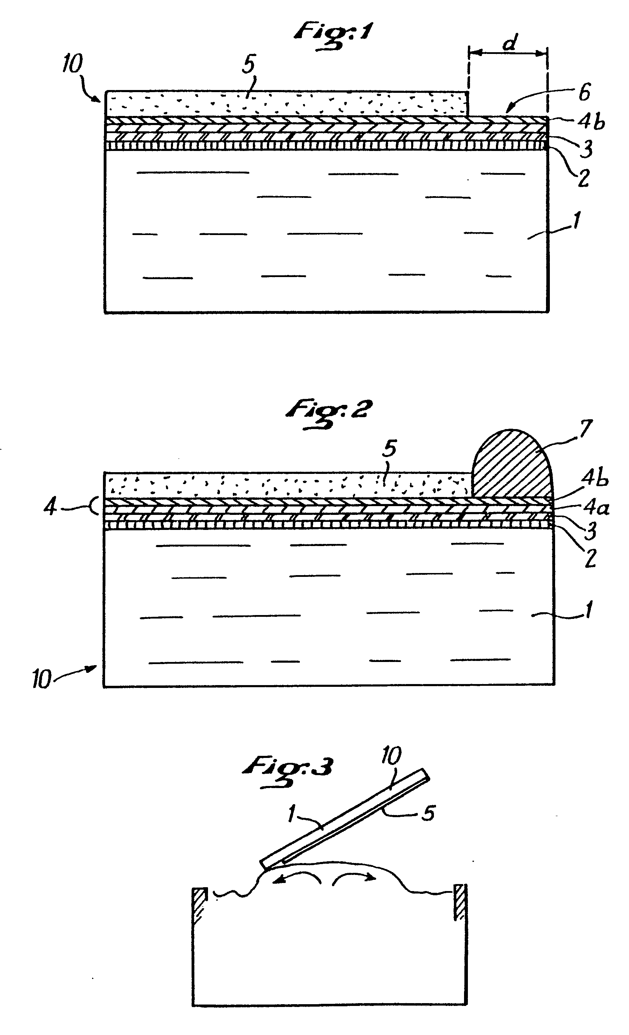

Sur la figure 1, on a représenté en coupe le bord d'un élément de pile 10 préparé pour recevoir une borne suivant le procédé conforme à la présente invention. Comme indiqué ci-dessous, et comme on va le voir ci-après, les proportions des épaisseurs des différentes couches ne sont pas respectées. L'élément de pile a la forme d'une bande, à bords parallèles s'étendant perpendiculairement au plan de la figure. Seul, un des bords est représenté. L'électrode est rectiligne.

Une photopile ou photodiode élémentaire au silicium amorphe est un assemblage complexe de couches minces déposées sur un substrat ou support, généralement en verre. La présente invention s'applique au cas du support en verre. L'élément de pile 10 comporte une plaque de verre 1 bien transparent d'épaisseur un ou deux millimètres. Sur le support est placée une électrode transparente 2. Elle assure la collecte du courant électrique engendré par la photodiode et doit simultanément laisser passer la lumière. On utilise pour cela des semi-conducteurs dégénérés dont la conductivité électrique est acceptable: oxyde d'étain Sn 02, ou oxyde mixte d'indium et d'étain. On trouve ensuite par exemple une ou plusieurs couches de silicium amorphe 3 (constituée elle-même de trois sous-couches distinctes : une sous-couche p dopée au bore, une sous- couche intrinsèque i, non dopée et une sous-couche n dopée au phosphore). La pile est complètée par une électrode arrière 4. C'est un film mince métallique opaque, déposé par exemple par pulvérisation cathodique. Les métaux employés sont principalement l'argent, l'aluminium et le nickel. Avantageusement, on prévoit une première couche 4a en aluminium par dessus laquelle est déposée une couche 4b en nickel, pour obtenir un meilleur contact et une dureté plus grande en surface.

En face arrière une résine copolymérisée 5 peut constituer une protection contre les agressions mécaniques (rayures) et chimiques légères (humidité). On peut aussi utiliser une seconde plaque de verre. La résine peut être déposée par sérigraphie. L'ensemble des couches 2 à 4 formant la cellule a une épaisseur qui est de l'odre du micron.

Afin de préparer la connexion de la couche de nickel 4b, la protection extérieure 5 est limitée à une distance d du bord de la plaque, laissant à nu une zone 6 de la couche de nickel sur cette largeur. Cette distance peut être avantageusement de l'ordre de un à quelques millimètres. Dans certaines applications, la surface dégagée peut être discontinue.

Sur la figure 2 on a représenté en coupe également une borne 7 constituée par un cordon d'étain, qui recouvre la zone 6 dégagée de l'électrode arrière 4. Cette borne s'étend sur tout le bord longitudinal de l'élément de pile, pour assurer la meilleure conductivité avec l'ensemble de l'électrode plate très mince. Grâce au procédé de l'invention, on obtient rapidement, en une seule opération courte, un cordon d'une épaisseur qui est normalement de 10 microns et peut aller jusqu'à 50. Cette épaisseur permet de souder un fil sans apport, en un point quelconque sur la longueur du cordon formant la borne. On peut utiliser des machines de soudure automatique. L'épaisseur est suffisante pour permettre la réalisation de contacts par simple pression contre le cordon d'étain. Il n'est pas nécessaire de rapporter du métal sur le bord de l'électrode.

L'opération de pose du cordon d'étain est réalisée par la technique dite "à la vague", conformément à la présente invention. Dans un mode de mise en oeuvre du procédé selon l'invention, l'élément défile à plat, de façon à être léché par la vague d'étain en mouvement. L'étain n'adhère pas sur l'isolant 5 qui peut former un dessin. Par contre il adhère bien sur le nickel 4b, qui a préalablement été passé au flux de soudure (simple passage des plaques sur un fluxeur à mousse ou un rouleau).

Selon l'invention, la vitesse de passage de la plaque sur la vague est assez rapide, et est comprise entre 1,5 et 5 mètres par minute, avantageusement entre 2 et 3 mètres par minute, et la plaque n'est pas préalablement chauffée. La couche 4 de l'électrode, métallique et bonne conductrice de la chaleur a une épaisseur de l'ordre du demi micron et n'a par conséquent aucune inertie thermique. C'est la présence du verre froid qui fixe et durcit l'étain déposé par la vague, qui est à environ 250°C et qui permet un dépôt épais. On peut avantageusement équiper la sortie du dispositif d'un couteau d'air chaud. Celui-ci ne fonctionne que le temps du passage de la plaque sur la vague et permet d'éviter la formation d'une goutte d'étain. La zone à garnir peut être présentée simultanément à la vague sur toute sa longueur, ou défiler perpendiculairement et le dépôt d'étain est progressif le long de l'électrode.

Au lieu de faire passer l'élément de pile horizontalement sur la vague, on peut le présenter obliquement, comme représenté schématiquement sur la figure 3 pendant un temps correspondant aux vitesses indiquées ci-dessus, c'est-à-dire de 1 à 2 secondes.

On a constaté que les dispositions inhabituelles d'étamage à la vague, où la cellule est introduite dans le bain par sa tranche ou sa bordure a permis d'obtenir une qualité de dépôt acceptable, sans goutte, d'une épaisseur supérieure à 10 microns, et naturellement sans couteau d'air. En effet, exceptionnellement pour l'exploitation d'une vague, il est possible de mettre l'objet en présence de l'étain par croisement du plan du support avec le plan de la vague et introduction de cette tranche de la cellule dans le mouvement de la vague, au lieu du mouvement habituel par le dessus ou le dessous du support dans un plan fixe passant par une génératrice de la surface de la vague d'étain.

La description qui précède a été faite à propos de l'électrode arrière. Il va de soi que le procédé s'applique tout aussi bien à l'électrode transparente en oxyde d'étain, pourvu que celle-ci soit dégagée convenablement pour pouvoir être mise en contact avec l'étain de la vague en évitant les court-circuits par une disposition appropriée de la couche de protection extérieure, et recouverte d'une couche d'accrochage.

La reproductibilité et la fiabilité du procédé sont obtenues par le simple réglage du temps de séjour de la cellule dans l'étain et de la vitesse de défilement.

L'application de la couche de protection, notamment par sérigraphie permet de réserver un dessin quelconque sur l'arrière de l'élément, avec des zones dégagées où l'étain peut s'accrocher. Ceci permet par exemple d'obtenir des points de contact à des potentiels différents. On peut aussi réaliser plusieurs cordons d'étain parallèles, et découper ensuite la plaque, en plusieurs éléments. On peut placer un masque sur la vague, laissant dégagée(s) une (ou plusieurs) buse pour contrôler la formation de cordons d'étain.

**Revendications**

1. Procédé de réalisation d'une borne de contact pour électrode en couche mince sur du verre comprenant, sur une plaque de verre d'une épaisseur de un à quelques mm, une électrode métallique, caractérisé en ce qu'un matériau d'étamage approprié est déposé par contact avec ladite surface en l'état fondu et la durée de contact de ladite surface avec la phase fondue est inférieure à deux secondes.

2. Procédé selon la revendication 1 dans lequel, une électrode est étamée sur une surface de contacts d'une lageur appropriée, caractérisé en ce que un alliage d'étain est déposé par un bain d'étain, par le procédé dit à la vague sur ladite surface de contact, l'élément étant présenté à la vague de préférence à la température ambiante et la vitesse de défilement étant comprise entre 1,5 et 5 mètres par minute.

3. Procédé selon la revendication 2 dans le lequel une protection isolante non mouillable par l'alliage fondu forme un dessin, avec des zones où l'électrode n'est pas recouverte par la protection isolante.

4. Procédé selon la revendication 1 dans lequel la ou les électrodes sont rectilignes et l'on dépose un ou des cordons d'étain.

5. Procédé selon les revendications 1,2 et 4 dans lequel on place un masque sur la vague laissant dégagée une ou plusieurs buses pour contrôler la formation du cordon d'étain.

6. Procédé selon la revendication 1 dans lequel la plaque de verre est introduite dans le bain par sa tranche ou sa bordure.

7. Procédé selon une des revendications 1 à 6 dans lequel l'électrode est garnie d'une couche de nickel avant la phase d'étamage.

8. Contact d'électrode obtenu par le procédé selon une des revendications 1 à 7.

9. Photopile ayant un contact selon la revendication 8.

*Fig:1*

*Fig:2*

*Fig:3*

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | FR-A-2 408 974 (R.T.C. LA RADIOTECHNIQUE-COMPELEC) * En entier * --- | 1,2,6,8 | H 01 L 31/02 H 01 L 31/0224 B 23 K 1/08 |
| A | 31ST ELECTRONIC COMPONENTS CONFERENCE, Atlanta, Georgia, 11-13 mai 1981, pages 149-155, IEEE, New York, US; T. KAWANOBE et al.: "Solder bump fabrication by electrochemical method for flip chip interconnection" * Pages 149-250 * --- | 1,7,8 | |
| A | PATENT ABSTRACTS OF JAPAN, vol. 9, no. 230 (E-343)[1953], 17 septembre 1985; & JP-A-60 84 885 (MATSUSHITA DENKI SANGYO K.K.) 14-05-1985 --- | | |
| A | FR-A-2 206 654 (RCA CORP.) ----- | | |

|  | DOMAINES TECHNIQUES RECHERCHES (Int. Cl.5) |
|---|---|
| | H 01 L B 23 K |

Le présent rapport a été établi pour toutes les revendications

| Lieu de la recherche | Date d'achèvement de la recherche | Examinateur |
|---|---|---|
| LA HAYE | 06-06-1990 | VISENTIN A. |